# EUROPEAN PATENT APPLICATION

(11) **EP 4 557 902 A1**
(43) Date of publication of application: **21.05.2025**
(21) Application number: 23839845.7
(22) Date of filing: 29.06.2023
(51) Int. Cl.: H05K 7/20, F28D 15/02

(54) **HEATING ELEMENT COOLING DEVICE**

(30) Priority: 15.07.2022 KR 20220087358
(71) Applicant: KMW Inc., Hwaseong-si, Gyeonggi-do 18462 (KR)
(72) Inventor: LEE, Hwang Ju, Incheon 22627 (KR); KIM, Dong Won, Bucheon-si Gyeonggi-do 14574 (KR); JANG, Jae Ho, Osan-si Gyeonggi-do 18102 (KR); LEE, Kang Hyun, Hwaseong-si Gyeonggi-do 18442 (KR); CHOI, In Hwa, Yongin-si Gyeonggi-do 17148 (KR)
(74) Representative: Impuls legal PartG mbB
(86) International application number: PCT/KR2023/009082
(87) International publication number: WO 2024/014751

(57) **Abstract**

Provided according to an embodiment of the present disclosure is a heating element cooling device comprising: a body part including a hollow portion in which working fluid is circulated and a wick portion which is disposed in at least a part of an inner wall of the body part and through which the working fluid flows to a heat source; a space part formed to extend from each of both ends of the body part and including a hollow portion; and a block part inserted into and welded to the space part.

## Description

### [CROSS-REFERENCE TO RELATED APPLICATIONS]

This application is based on, and claims priority from, Korean Patent Application Number 10-2022-0087358, filed July, 15, 2022, the disclosure of which is incorporated by reference herein in its entirety.

### [TECHNICAL FIELD]

The present disclosure relates to a heating element cooling device.

### [BACKGROUND ART]

Contents described here merely provides background information for the present disclosure and does not constitute prior art.

Electronic components that constitute electronic devices generate heat when operating. Electronic devices such as computers, servers, and high-performance antenna devices include electronic components such as IC chips, CPUs, and transceiver elements. These electronic components (hereinafter referred to as "heating elements") generate a large amount of heat when operating. When the heating elements generating heat are not cooled, their performance may be significantly reduced or, in some cases, damaged, making operation difficult. Therefore, the heating elements should be cooled.

Recent electronic devices are becoming slimmer, more integrated, and more high-performance, which is causing the gap between components to narrow and the heat load to increase. Accordingly, cooling of heating elements is almost essential, and most electronic devices are equipped with cooling devices to cool the heating elements.

A heat pipe type or vapor chamber type cooling device that are equipped so that a certain refrigerant is circulated while the refrigerant changes phases depending on the surrounding temperature difference are widely used.

The heat pipe type or vapor chamber type cooling device is manufactured by forming a hollow portion (or internal space) and by sintering a capillary wick, which is a porous body, inside a pipe-shaped (or panel-shaped) body tube (or body panel) made of a heat-conductive material.

When a separate heat sink is additionally attached to the outside of the heat pipe type or vapor chamber type cooling device, both ends of the cooling device may protrude beyond the heat sink. In this case, since both ends of the cooling device do not include a wick portion or a separate support part, there is a problem that both ends of the cooling device are easily damaged by impact, or the like.

### [SUMMARY]

Provided according to an embodiment of the present disclosure is a heating element cooling device comprising: a body part including a hollow portion in which working fluid is circulated and a wick portion which is disposed in at least a part of an inner wall of the body part and through which the working fluid flows to a heat source; a space part formed to extend from each of both ends of the body part and including a hollow portion; and a block part inserted into and welded to the space part.

### [DETAILED DESCRIPTION OF INVENTION]

### [TECHNICAL PROBLEMS]

A heating element cooling device according to one embodiment may have separate block parts coupled to both ends of a body part.

The problems to be solved by the present disclosure are not limited to the problems mentioned above, and other problems not mentioned will be clearly understood by those skilled in the art from the description below.

### [TECHNICAL SOLUTION]

Provided according to an embodiment of the present disclosure is a heating element cooling device comprising: a body part including a hollow portion in which working fluid is circulated and a wick portion which is disposed in at least a part of an inner wall of the body part and through which the working fluid flows to a heat source; a space part formed to extend from each of both ends of the body part and including a hollow portion; and a block part inserted into and welded to the space part.

### [EFFECT OF INVENTION]

According to one embodiment, the heating element cooling device, it is possible to prevent both ends of the heating element cooling device from being easily damaged by impact or the like by combining separate block parts at both ends of the body part.

### [BRIEF DESCRIPTION OF THE DRAWING]

FIG. 1 is a combined perspective view of a heating element cooling device according to one embodiment of the present disclosure.
FIG. 2 is an exploded perspective view of the heating element cooling device according to one embodiment of the present disclosure.
FIG. 3 is a cross-sectional side view of the heating element cooling device according to one embodiment of the present disclosure.
FIG. 4 is an enlarged cross-sectional view of a body part and a block part of the heating element cooling device according to one embodiment of the present disclosure.
FIG. 5 is a view illustrating a block part of the heating element cooling device according to one embodiment of the present disclosure.

### [BEST MODE FOR CARRYING OUT THE INVENTION]

Hereinafter, some embodiments of the present disclosure will be described in detail with reference to the accompanying drawings. In the following description, like reference numerals preferably designate like elements, although the elements are shown in different drawings. Further, in the following description of some embodiments, a detailed description of related known components and functions when considered to obscure the subject of the present disclosure will be omitted for the purpose of clarity and for brevity.

Additionally, alphanumeric codes such as first, second, i), ii), (a), (b), etc., in numbering components are used solely for the purpose of differentiating one component from the other but not to imply or suggest the substances, the order, or sequence of the components. Throughout this specification, when parts "include" or "comprise" a component, they are meant to further include other components, not excluding thereof unless there is a particular description contrary thereto. The terms such as 'unit,' 'module,' and the like refer to one or more units for processing at least one function or operation, which may be implemented by hardware, software, or a combination thereof.

A heating element cooling device 1 according to one embodiment of the present disclosure is a heat dissipation component that can apply a heat dissipation method of the concept excluding the induction of phase change of refrigerant by a compressor. The heating element cooling device is designed to cool a heat generating element that is electrically driven and generates heat by transferring heat while causing a phase change solely by heat supplied from the outside under atmospheric pressure without using a compressor, and can be applied to a vapor chamber, a heat pipe, a heat sink, or the like.

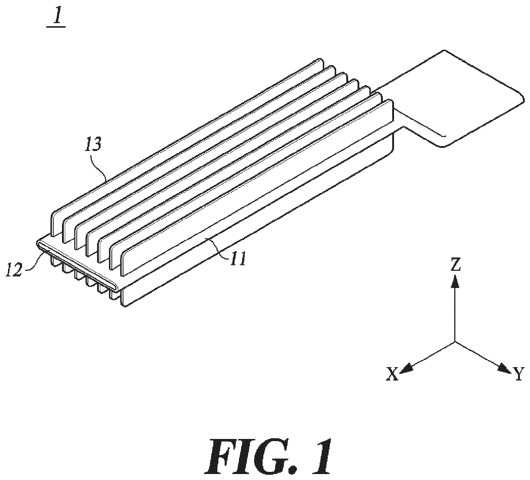

FIG. 1 is a combined perspective view of a heating element cooling device according to one embodiment of the present disclosure.

Referring to FIG. 1, a heating element cooling device 1 of the present disclosure may include all or some of a body part 11, a block part 12, and a heat sink 13.

The body part 11 may be a flat type part in which a length in a width direction (y-axis direction in FIG. 1) is relatively long compared to the length in a thickness direction (z-axis direction in FIG. 1). The body part 11 may include a hollow portion which is filled with refrigerant and through which the refrigerant can move.

A wick portion 113 may be formed on an inner wall of the body part 11. The wick portion 113 may be formed by applying heat to an inner wall of the body part 11 using the high-density energy of a laser and scratching or wounding the inner wall to a certain depth or more. The wick portion 113 may be formed to generate a capillary phenomenon in a working fluid, such as a refrigerant, filling the body part 11 to cause the working fluid to flow. The wick portion 113 may cause a liquid working fluid to flow from a condense unit to an evaporate unit. For example, when heat is transferred to the inside of the heating element cooling device 1, the working fluid filling the inside may undergo a phase change due to the transferred heat. The working fluid that has undergone a phase change may radiate heat to the outside by using the wick portion 113 by means of surface tension and capillary force.

The wick portion 113 may be formed parallel to a longitudinal direction (x-axis direction of FIG. 1) of the body part 11. The wick portions 113 may be formed in parallel at a predetermined interval in the width direction of the body part 11. The wick portion 113 may be formed to protrude from the upper and lower inner wall in the thickness direction of the body part 11.

The heat sink 13 may be formed on at least a portion of the outer wall of the body part 11. The heat sink 13 may be formed on the outer wall in the thickness direction of the body part 11. The heat sinks 13 may be formed in parallel at a predetermined interval in the width direction of the body part 11. The heating element cooling device 1 of the present disclosure has the effect of additionally dissipating heat together with the body part 11 by forming the heat sink 13 on the outer wall of the body part 11. The heating element cooling device 1 of the present disclosure has the effect of being easy to manufacture even when the heat sink 13 is formed on the body part 11 by manufacturing the heating element cooling device 1 using an extrusion method.

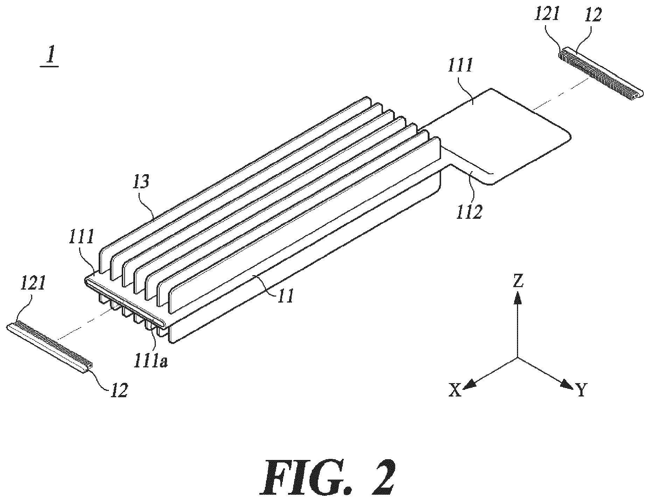

FIG. 2 is an exploded perspective view of the heating element cooling device according to one embodiment of the present disclosure.

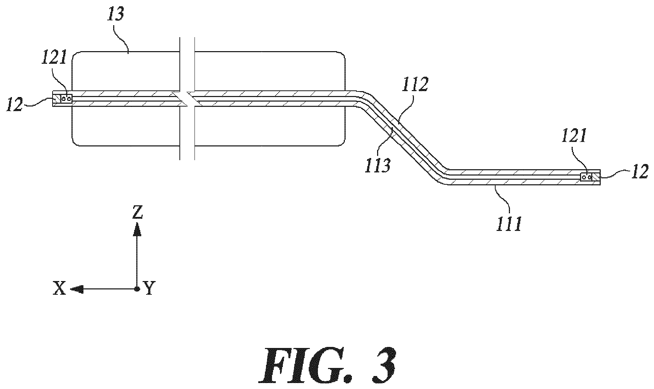

FIG. 3 is a cross-sectional side view of the heating element cooling device according to one embodiment of the present disclosure.

Referring to FIGS. 2 and 3, the heating element cooling device 1 of the present disclosure may further include a space part 111 and a bent part 112.

The space part 111 may be formed at both ends of the body part 11 in the longitudinal direction. For example, the space part 111 may be formed to protrude in the longitudinal direction of the body part 11 from the heat sink 13 formed on the outer wall of the body part 11. By forming the space part 111 at both ends of the body part 11, the working fluid can freely circulate within the body part 11. As a result, the fluidity of the working fluid increases, and the heat dissipation efficiency of the heating element cooling device 1 can be increased.

The space part 111 may be formed to extend from both ends of the body part 11 in the longitudinal direction, and formed integrally with the body part 11. The space part 111 may include a hollow portion 111a which is filled with the working fluid and through which the working fluid moves. However, unlike the body part 11, the space part 111 does not have the wick portion 113 or a separate support part formed on the inner wall. Therefore, when the space part 111 is sealed as is with a vacuum, there is a problem that both ends of the heating element cooling device 1 are easily damaged by external impact, or the like.

The block part 12 of the heating element cooling device 1 of the present disclosure may be inserted into the hollow portion 111a of the space part 111. The block part 12 is inserted into the space part 111, and the block part 12 and the space part 111 may be joined to each other by welding. The block part 12 may have a shape corresponding to the width and length of the space part 111.

The block part 12 may be inserted into the space part 111 and the entire circumference of the block part may be welded. The entire finished surface may be welded using the wobble welding method. In this case, the wobble welding refers to a method of performing welding while drawing a certain pattern during the welding. The welding conditions are explained as follows.

When welding the block part 12 and the space part 111, a continuous welding method may be used. In this case, the wavelength of the laser used may be 1030 nm. The welding may be performed with a dual beam having two beam characteristics, and an output ratio of a CORE beam and a RING beam may be 4:6. For example, when the welding machine is used with an output of 2 KW, the output of the CORE beam may be 800 W and the output of the RING beam may be 1.2 KW. The size and frequency of the wobble may be 0.15 mm and 200 Hz, respectively. The output of the laser may be adjusted from 90% (1100 W) to 10% (750 W). That is, 90% of a certain length may be welded with 1100 W and the last 10% may be welded with 750 W. However, the welding conditions of the block part 12 and the space part 111 of the present disclosure are not limited thereto and may be designed in various ways as needed.

The bent part 112 may be formed by bending at least a portion in the longitudinal direction of the body part 11. The bent part 112 may be bent at a predetermined angle within a range that does not impede the movement of the working fluid within the body part 11. The body part 11 excluding the bent part 112 may be formed in parallel. However, the present disclosure is not limited thereto, and the number of bent parts 112, the angle of the bent part, and the shape of the body part 11 may be designed in various ways as needed.

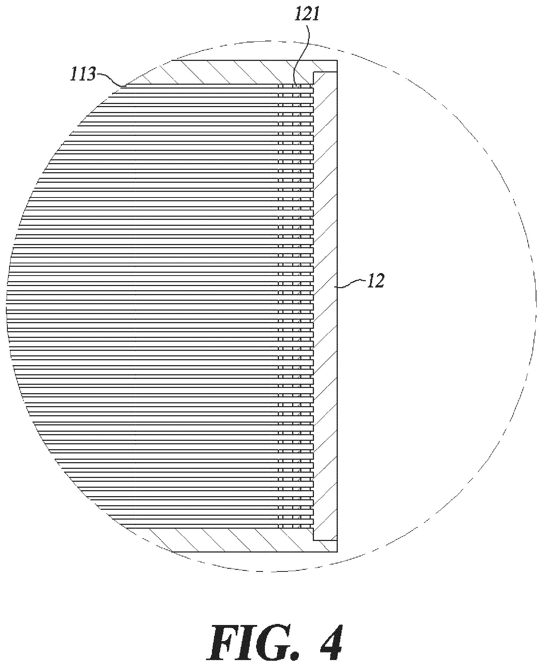

FIG. 4 is an enlarged cross-sectional view of the body part and block part of the heating element cooling device according to one embodiment of the present disclosure.

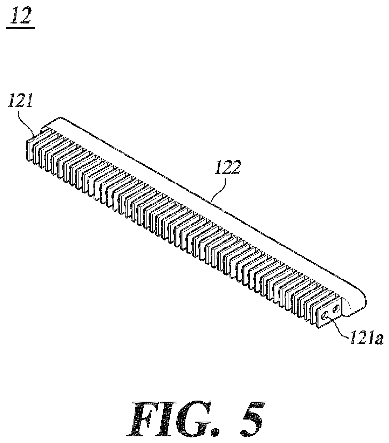

FIG. 5 is a view illustrating the block part of the heating element cooling device according to one embodiment of the present disclosure.

Referring to FIGS. 4 and 5, the block part 12 of the heating element cooling device 1 of the present disclosure may include a support part 121 and a body 122.

The support parts 121 may be arranged at a predetermined interval in the width direction of the block part 12. The support parts 121 may be arranged at a predetermined interval, but may be arranged in a manner aligned parallel to the wick portion 113 formed on the inner wall of the body part 11. By arranging the support parts 121 in a manner aligned parallel to the wick portion 113, the working fluid can be smoothly circulated through the body part 11 and the space part 111.

When the block part 12 is inserted into the space part 111, the body 122 closes the hollow portion 111a of the space part 111, and the block part 12 and the space part 111 are welded, thereby sealing the space part 111 in a vacuum. In this case, the shape of the body 122 may correspond to the shape of the hollow portion 111a of the space part 111.

The support part 121 may further include one or more grooves 121a through which the working fluid can circulate. Since the support part 121 includes one or more circular grooves 121a, the working fluid can smoothly circulate through the body part 11 and the space part 111. The grooves 121a formed in each support part 121 may be formed to correspond to the grooves 121a formed in the neighboring support part 121. However, the shapes and number of the support part 121 and the grooves 121a are not limited thereto and may be designed in various ways as needed.

The block part 12 may have a shape corresponding to the width and length of the space part 111. The body 122 may have a shape corresponding to the hollow portion 111a of the space part 111. The thicknesses of the body 122 and the support part 121 may correspond to the thickness of the hollow portion 111a of the space part 111. The length of the block part 12 may correspond to the length of the space part 111. Therefore, the block part 12 may support the space part 111 in which the wick portion 113 or a separate support part is not formed on the inner wall.

The block part 12 may be inserted into the space part 111, and the block part 12 and the space part 111 may be joined to each other by welding. Therefore, when the space part 111 is sealed as is with a vacuum, the block part 12 can support the space part 111, and thus, it is possible to prevent both ends of the heating element cooling device 1 from being damaged easily by external impact, or the like.

Although exemplary embodiments of the present disclosure have been described for illustrative purposes, those skilled in the art will appreciate that various modifications, additions, and substitutions are possible, without departing from the idea and scope of the claimed invention. Therefore, exemplary embodiments of the present disclosure have been described for the sake of brevity and clarity. The scope of the technical idea of the present embodiments is not limited by the illustrations. Accordingly, one of ordinary skill would understand that the scope of the claimed invention is not to be limited by the above explicitly described embodiments but by the claims and equivalents thereof.

## Claims

1. A heating element cooling device comprising:
a body part including a hollow portion in which working fluid is circulated and a wick portion which is disposed in at least a part of an inner wall of the body part and through which the working fluid flows to a heat source;
a space part formed to extend from each of both ends of the body part and including a hollow portion; and
a block part inserted into and welded to the space part.

2. The heating element cooling device of claim 1, wherein the wick portion is not disposed on an inner wall of the space part.

3. The heating element cooling device of claim 1, wherein the wick portion is disposed in a longitudinal direction of the body part at a predetermined interval in a width direction of the body part.

4. The heating element cooling device of claim 1, wherein the block part further includes a support part arranged at a predetermined interval in a width direction of the block part.

5. The heating element cooling device of claim 4, wherein the support part further includes one or more grooves through which the working fluid circulates.

6. The heating element cooling device of claim 4, wherein
the support part is disposed to be arranged in parallel with the wick portion.

7. The heating element cooling device of claim 1, wherein the body part further includes a bent part of which at least a part is bent.

8. The heating element cooling device of claim 1, wherein the block part has a shape corresponding to a width and length of the space portion.

9. The heating element cooling device of claim 1, further comprising a heat sink disposed in at least a portion of an outer wall of the body part.
